# EUROPEAN PATENT APPLICATION

(11) **EP 4 675 188 A1**
(43) Date of publication of application: **07.01.2026**
(21) Application number: 25187615.7
(22) Date of filing: 04.07.2025
(51) Int. Cl.: F24F 11/36

(54) **SERVICE ACCESS MECHANISM FOR COOLING SYSTEM**

(30) Priority: 05.07.2024 US 202463667970 P
(71) Applicant: Vertiv Corporation, Westerville, OH 43082 (US)
(72) Inventor: KURTZ, Obadiah Michael, Westerville, 43082 (US); BLASER, Colin Lewis, Westerville, 43082 (US); MILLER, Oliver McKenzey, Westerville, 43082 (US); RAVEN, Matthew Alan, Westerville, 43082 (US); HARLEY, Isaac Shawn, Westerville, 43082 (US); BREUER, Thomas Christopher, Westerville, 43082 (US)
(74) Representative: Cousens, Nico

(57) **Abstract**

A cooling system comprises a cabinet, a compressor, an evaporator, a refrigerant, at least one sensor, a controller, and at least one sliding mechanism. The cabinet comprises a first compartment and a second compartment. The compressor is positioned within the cabinet. The evaporator is positioned within the cabinet. The refrigerant is received by the compressor and the evaporator. The sensor measures refrigerant leak data. The controller determines the presence of a refrigerant leak based on the refrigerant leak data from the sensor. The sliding mechanism is configured to slide in and out of the cabinet. The sliding mechanism comprises at least one sensor.

## Description

### TECHNICAL FIELD

The present disclosure relates to a cooling system, more specifically, to a high-density liquid cooling system having a service access mechanism for electronic devices.

### BACKGROUND

Various techniques are being used to cool electronic devices (e.g., processors, memories, networking devices, and other heat generating devices) that are located on a server or network rack tray in a data center. For instance, forced convection may be created by providing a cooling airflow over the devices. Fans located near the devices, fans located in computer server rooms, and/or fans located in ductwork in fluid communication with the air surrounding the electronic devices, may force the cooling airflow over the tray containing the devices.

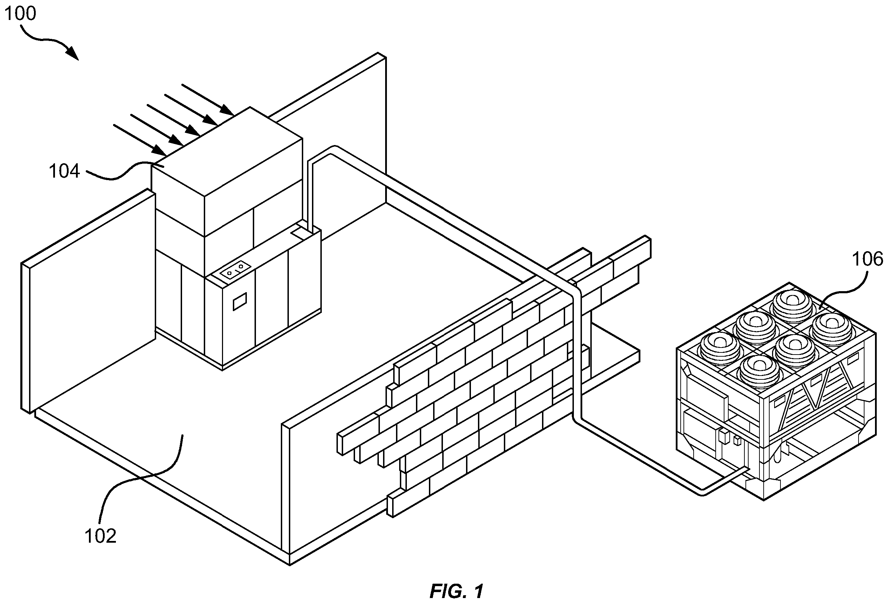

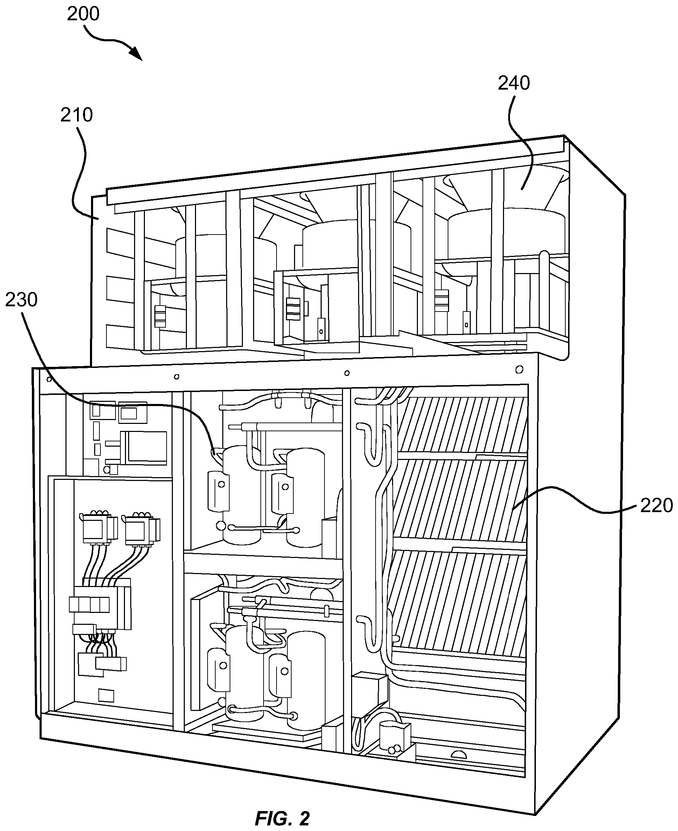

FIG. 1 shows a typical cooling system 100 for a building, e.g., a data center 102 having an indoor unit 102 and an outdoor unit 106 as a split air conditioning system. The indoor unit 104 includes an evaporator, a fan, a compressor, and an expansion valve, and the outdoor unit 106 includes a condenser coil, a fan, and a pump. The indoor unit 104 inside the building (e.g., data center 102) fluidly communicates with the outdoor unit 106 located outside the building through a closed refrigeration circuit. FIG. 2 shows an indoor unit 200 formed of a cabinet or frame 210 having one or more compartments where the evaporator and a fan 240 are in a first compartment 220 and the compressor is in an enclosed second compartment 230. The refrigerant flowing within the circuit is generally formulated to undergo phase changes within the normal operating temperatures and pressures of the system 100 so that quantities of heat can be exchanged by virtue of the latent heat of vaporization of the refrigerant. As such, the refrigerant flowing within the system 100 travels through multiple conduits and components of the circuit.

Commonly used refrigerants for commercial HVAC systems include R-410A, R-407C, R-134a, etc. which are hydrofluorocarbons (HFCs) with non-flammability and low toxicity. Refrigeration and air conditioning applications are under increased regulatory pressure to reduce the global warming potential of the refrigerants they use. Several refrigerants have been developed that are considered low global warming potential options, and they have an ASHRAE (American Society of Heating, Refrigerating, and Air-Conditioning Engineers) classification as A2L, which is flammable. The UL (Underwriters Laboratory) 60335-2-40 standard, and similar standards, specify a predetermined (M1) level for A2L refrigerants (e.g., R-1234yf, R-1234ze, R-452B, R-454B, R-32, etc.) and indicate that A2L refrigerant charge levels below the predetermined level do not require leak detection. However, while A2L refrigerants are only partially flammable due to reduced propagation, they still pose a combustion risk. Thus, it is important to detect any A2L leak within the HVAC system, e.g., an enclosed space of the indoor unit.

Current HVAC systems often experience failures of refrigerant coils within the refrigerant flow loop. This may take the form of condenser or evaporator coil failures. In addition, current mechanisms to detect these failures have proven unsuccessful in discriminating true refrigerant leaks from ambient hydrocarbon emissions as might be experienced from the use of cleaning solvents and/or other cleaning materials that are typically used in a commercial building context. Accordingly, if a refrigerant leak occurs in an enclosed space, e.g., the first compartment, due to such failures or any other failures, there is a higher risk of combustion when A2L refrigerants are used. For this reason, a system that can detect refrigerant leaks in an HVAC system and provide monitoring/logging of refrigerant leaks represents a long-felt need within the HVAC servicing industry, especially in light of recently enacted EPA regulatory requirements.

Thus, it is necessary or indeed required for the system using A2L refrigerant to be equipped with an A2L refrigerant leak detection sensor(s). Particularly, as the trend of moving from A1 refrigerant to A2L refrigerant, to the extent that refrigerant leaks are possible in air conditioning systems, it is desirable to have leak detection systems in place when A2L refrigerants are in use for indoor units for heating, ventilation and air conditioning (HVAC) products and other similar systems.

Serviceability is a major requirement for A2L sensors. However, due to the installation location of an A2L refrigerant leak detection sensor, the sensor is not easily accessible. For instance, the A2L refrigerant leak detection sensor is generally located at the bottom of the indoor cooling unit as the A2L refrigerant sinks toward the bottom due to its higher density than air. In addition, the ASHRAE guidelines provide recommendations and requirements for the installation location for refrigerant leak detection sensors, and the recommendation locations are often inaccessible for maintenance without disconnecting and moving the entire cooling system.

In view of the foregoing, there needs mechanism capable of providing easy and secure accessibility to a refrigerant leak detection sensor when necessary.

### SUMMARY

Embodiments described herein relate to techniques for cooling data centers. In particular, systems and methods of the present disclosure provide new and novel mechanisms that allow servicing refrigerant leak sensors without disassembling or removing units in the field. This can save unnecessary labor time and cost in the case of leak sensor failures and further reduce downtime that would otherwise be required to service the sensors.

In accordance with at least one embodiment of the present disclosure, a cooling system comprises a cabinet, a compressor, an evaporator, a refrigerant, at least one sensor, a controller, and at least one sliding mechanism. The cabinet comprises a first compartment and a second compartment. The compressor is positioned within the cabinet. The evaporator is positioned within the cabinet. The refrigerant is received by the compressor and the evaporator. The sensor measures a refrigerant leak data. The controller determines the presence of a refrigerant leak based on the refrigerant leak data from the sensor. The sliding mechanism is configured to slide in and out of the cabinet. The sliding mechanism comprises the at least one sensor.

In some embodiments, the cabinet comprises an opening through which a portion of the sliding mechanism is received.

In some embodiments, the sensor and the sliding mechanism are positioned adjacent to a lowest point of the cabinet when in the first position.

In some embodiments, the sliding mechanism comprises a guide rail disposed on the bottom of the cabinet and a sliding bar configured to slide along the guide rail. The sensor is detachably disposed on the sliding bar. The sliding bar is configured to slide to be completely inside the cabinet in a first position and to be outside the cabinet in a second position to expose the sensor outside the cabinet.

In some embodiments, the sensor is disposed in the second compartment when in the first position. The evaporator is positioned in the second compartment.

In some embodiments, the refrigerant leak data comprises at least one of a refrigerant concentration, a temperature, a pressure, or a humidity.

In some embodiments, the at least one sensor includes at least one of a temperature sensor, a pressure sensor, a humidity sensor, or a density sensor.

In some embodiments, the refrigerant is an A2L refrigerant.

In accordance with at least one embodiment of the present disclosure, the sliding mechanism for a cooling system comprises a guide rail, a sliding bar received within the guide rail, and the at least one sensor. The sensor is detachably disposed on the sliding bar. The sensor is configured to measure a refrigerant leak data. The sliding bar is configured to slide between a first position and a second position.

In some embodiments, the cooling system further comprises a controller configured to receive the refrigerant leak data from the sensor.

In accordance with at least one embodiment of the present disclosure, the cooling system comprises a cabinet, an evaporator positioned within the cabinet, a compressor positioned within the cabinet, a refrigerant to be received by the evaporator and the compressor, a sensor, and a controller. The sensor measures refrigerant leak data. The sensor is movable between a first position in which the sensor is within the cabinet and a second position in which the at least one sensor is outside the cabinet. The controller determines a presence of a refrigerant leak based on the refrigerant leak data from the sensor.

In some embodiments, the cooling system comprises a sliding mechanism configured to move the sensor between the first position and the second position. The sensor is detachably disposed on a portion of the sliding mechanism.

In some embodiments, the sliding mechanism comprises a guide rail and a sliding bar received by a portion of the guide rail. The sliding bar is movable relative to the guide rail. The sensor is selectively coupled to the sliding bar.

In some embodiments, the sliding mechanism moves between the first position and the second position in response to a force applied to the sliding bar.

In some embodiments, the sliding mechanism moves between the first position and the second position in response to a change of state of an input button. The input button is in electrical communication with the controller.

Other aspects and advantages of the invention will become apparent from the following detailed description, taken in conjunction with the accompanying drawings, illustrating by way of example the principles of the invention.

### BRIEF DESCRIPTION OF THE DRAWINGS

The disclosure will be readily understood by the following detailed description in conjunction with the accompanying drawings, wherein like reference numerals designate like elements:
FIG. 1 shows an example of a typical cooling system for a data center;
FIG. 2 shows a perspective view of an indoor unit of the typical cooling system of FIG. 1;
FIG. 3 shows a perspective view of an indoor unit enclosure of a cooling system having a sliding mechanism according to embodiments of the present disclosure;
FIG. 4A shows the sliding mechanism in an open state according to embodiments of the present disclosure; and
FIG. 4B shows the sliding mechanism in a closed state according to embodiments of the present disclosure.

### DETAILED DESCRIPTION

The figures described above and the written description of specific structures and functions below are not presented to limit the scope of what Applicant has invented or the scope of the appended claims. Rather, the Figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's goal for the commercial embodiment. Such implementation-specific decisions may include and likely are not limited to, compliance with system-related, business-related, government-related, and other constraints, which may vary by specific implementation, location, and from time to time. While a developer's efforts might be complex and time-consuming in an absolute sense, such efforts would be, nevertheless, a routine undertaking for those of skill in this art having the benefit of this disclosure. It must be understood that the inventions disclosed and taught herein are susceptible to numerous and various modifications and alternative forms.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the inventions or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

The proposed systems provide a simple solution to access sensors as needed and return them to their initial location. By implementing this solution, it is possible to avoid suboptimal design changes and allow for servicing refrigerant leak sensors without disassembling or removing units in the field. This saves work time and reduces downtime required to service the sensor in the event of a leak sensor failure. The proposed system allows the use of existing devices with minimal reconfiguration. Additionally, the proposed system can save customers the downtime experienced when a sensor fails and enable sensor servicing to be more efficient. As a result, customers will experience both cost and time savings.

The proposed systems provide a sliding channel mechanism that can be mounted with sensors, e.g., refrigerant leak sensors. The sliding channel mechanism can be installed to slide through a frame of an indoor cooling unit and underneath a coil section inside the indoor cooling unit to place the sensors in the location that poses the highest risk of leaks. When the sensors eventually need to be replaced or undergo maintenance, a service technician can easily pull the sliding channel mechanism to reach the sensors.

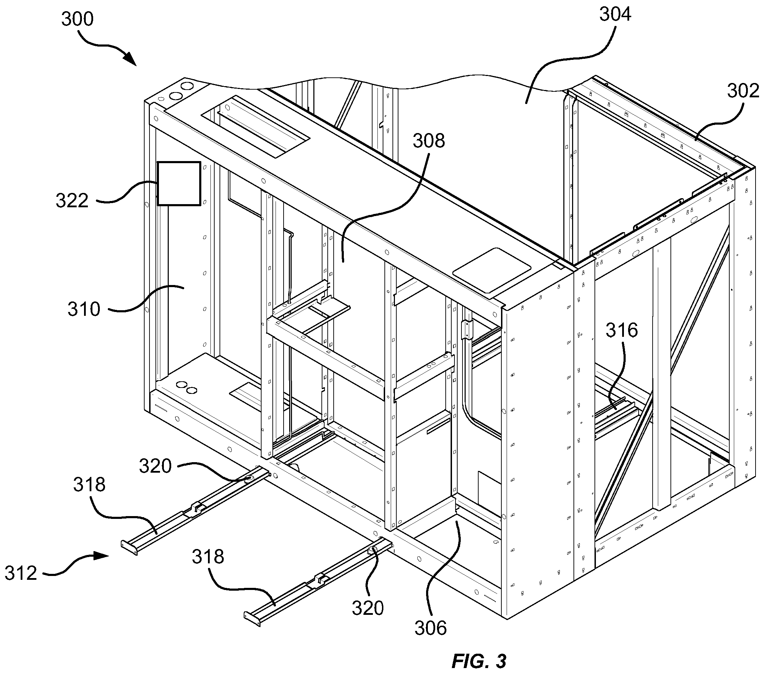

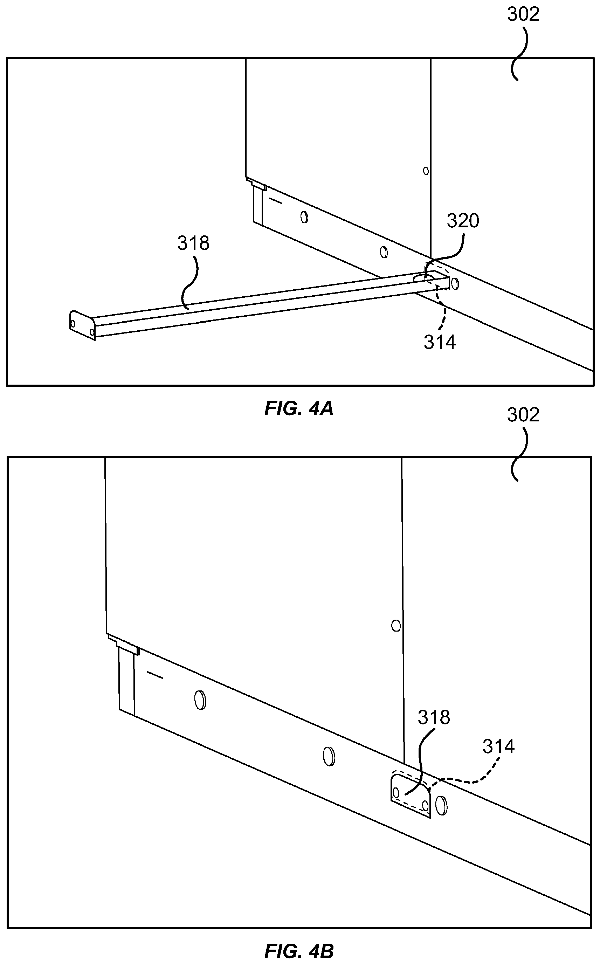

FIG. 3 shows a perspective view of a system housing an indoor unit of a cooling system having a sliding mechanism according to embodiments of the present disclosure. FIG. 4A shows the sliding mechanism in an open state according to embodiments of the present disclosure. FIG. 4B shows the sliding mechanism in a closed state according to embodiments of the present disclosure.

The system 300 may be used for a direct expansion (DX) air conditioning unit, also called a DX unit, which cools indoor air using a condensed refrigerant liquid. As described above, a split air conditioning system (e.g., FIG. 1) puts the condenser and fans outside a building and the compressor, evaporator, and fans inside the building. The unit then pumps the refrigerant to a compressor, which compresses the gas and passes it through another heat exchanger, the condenser, outside the building. The heat that has been absorbed by the refrigerant is released to the outdoor air, and the cooled, compressed refrigerant is once again in liquid form. The unit pumps the cooled refrigerant liquid back into the evaporator and the cycle begins again.

The system 300 shown in FIG. 3 may be equivalent to the frame of the indoor unit ("104" of FIG. 1 or "200" of FIG. 2). For instance, the external structure of the system 300 is a frame 302 for housing indoor units (compressor, evaporator, etc.). The frame 302 may be divided into one or more compartment spaces. For instance, the system 300 may have a first compartment 304 in which an evaporator and a compressor are housed, and may further have second, third, and3 fourth compartments 306, 308, and 310. The number of compartments is not limited to what is shown in the drawings but can be anywhere from one, two, three, four, five, etc. In addition, the compartments may be completely or partially separated from each other by separation walls and windows.

In some embodiments, the system 300 may include one or more sliding mechanisms 312 to slide in and out at the lower portion of the frame 302. The system 300 may have one or more openings 314 formed on the lower portion of the frame 302, through which the one or more sliding mechanisms 312 can respectively slide. In some embodiments, each sliding mechanism 312 may include a guide rail 316 and a sliding bar 318 slidably connected with the guide rail 316. A standard guide rail configuration, which allows the sliding motion, can be applied here, for example, curved, bolt-on, drop-in, W-beam, etc. Further, various materials can be used for the sliding mechanisms 312, e.g., metal, plastic, etc.

In some embodiments, the system 300 may include one or more sensors 320 detachably positioned on the respective one or more sliding bars 318. The sensors 320 may be located toward the back side of the frame 302 to be in the first compartment 316 when the one or more sliding bars 318 are in a closed position (or first position), i.e., slid all the way inside the frame 302. This configuration can accommodate the one or more sensors 320 to be positioned in the first compartment 316, e.g., where an evaporator is, to detect a refrigerant leak, particularly A2L refrigerant.

However, the location of the one or more sensors 320 can vary based on the application of the system 300, serviceability, etc. For instance, the one or more sensors 320 may be located closer to the other end of the respective one or more sliding bars 318, or alternatively, in the middle of the respective one or more sliding bars 318. In some embodiments, there may be more than one sensor on each sliding bar 318. Further, the locations of the sliding mechanisms 312 are not limited to what is shown in the drawings. The sliding mechanism 312 may be slidably installed at each end of the frame 312, or one sliding mechanism 312 may be installed in the center of the bottom portion of the frame 312.

In some embodiments, the system 300 may further include a controller 322 installed inside one of the compartments 304, 306, 308, or 310. Alternatively, each compartment may have a controller installed therein, or an externally connected controller may communicate with the system 300 (e.g., sensors 320).

The controller 322 may be configured to communicate with the one or more sensors 320, by wire or wirelessly. When a sensing value detected by the one or more sensors 320 is outside a threshold or when there is a fault detected in the one or more sensors 320, the controller 322 may output an alarm in the form of, e.g., audio, video, haptic, etc. In this regard, the controller 322 may include a graphical user interface to visually output an alarm. In some embodiments, the controller 322 may include input buttons (touch buttons or push buttons) for a user to manipulate. When an alarm is generated by the controller 322, a user may manually pull out the one or more sliding bars 318 or operate a button on the controller 322 to slide the one or more sliding bars 318 out as shown in FIG. 4A.

The one or more sensors 320 are detachably installed on the one or more sliding bars 318, such that, a user can easily detach and inspect the one or more sensors 320. Once the inspection and service are completed, the user can either manually slide the one or more sliding bars 318 back in or press a button to slide in, as shown in FIG. 4B.

Also disclosed are the following numbered clauses:
1. A cooling system, the cooling system comprising:
   a cabinet;
   an evaporator positioned within the cabinet;
   a compressor positioned within the cabinet;
   a refrigerant configured to be received by the evaporator and the compressor; and
   at least one sensor measuring refrigerant leak data, the at least one sensor movable between a first position in which the at least one sensor is within the cabinet and a second position in which at least one sensor is outside the cabinet; and
   a controller configured to determine a presence of a refrigerant leak based on the refrigerant leak data from the at least one sensor.
2. The cooling system of clause 1, further comprising
   a sliding mechanism configured to move the sensor between the first position and the second position, wherein the sensor is detachably disposed on a portion of the sliding mechanism.
3. The cooling system of clause 1 or 2, the sliding mechanism comprising
   a guide rail, and
   a sliding bar received by a portion of the guide rail, the sliding bar movable relative to the guide rail,
   wherein the sensor is selectively coupled to the sliding bar.
4. The cooling system of any preceding clause, wherein the sliding mechanism moves between the first position and the second position in response to a force applied to the sliding bar.
5. The cooling system of any preceding clause, wherein the sliding mechanism moves between the first position and the second position in response to a change of state of an input button, and wherein the input button is in electrical communication with the controller.
6. The cooling system of any preceding clause, wherein the refrigerant is an A2L refrigerant.

As described above, one aspect of the present system is to facilitate the accessibility of electronic devices that are typically not accessible due to structural limitations and arrangements. The present disclosure recognizes the need to improve the current configuration for a user or operator to reach the electronic sensors that need servicing, without disassembling the entire system where the electronic devices are located, and further to reduce the downtime for unnecessary manual efforts of disassembling and assembling. Therefore, the present disclosure can reduce the cost and time while promoting the use or service of electronic devices more easily.

Each of the components and their constituent parts, and other variations described herein may include corresponding features described with reference to each of the other components and features described without limitation.

In this application, including the definitions below, the term "module" or the term "controller" may be replaced with the term "circuit." The term "module" refers to or includes: an Application Specific Integrated Circuit (ASIC); a digital, analog, or mixed analog/digital discrete circuit; a digital, analog, or mixed analog/digital integrated circuit; a combinational logic circuit; a field programmable gate array (FPGA); a processor circuit (shared, dedicated, or group) that executes code; a memory circuit (shared, dedicated, or group) that stores code executed by the processor circuit; other suitable hardware components that provide the described functionality; or a combination of some or all of the above, such as in a system-on-chip.

The module may include one or more interface circuits. In some examples, the interface circuits may include wired or wireless interfaces that are connected to a local area network (LAN), the Internet, a wide area network (WAN), or combinations thereof. The functionality of any given module of the present disclosure may be distributed among multiple modules that are connected via interface circuits. For example, multiple modules may allow load balancing. In a further example, a server (also known as remote, or cloud) module may accomplish some functionality on behalf of a client module.

The term code, as used above, may include software, firmware, and/or microcode, and may refer to programs, routines, functions, classes, data structures, and/or objects. The term shared processor circuit encompasses a single processor circuit that executes some or all code from multiple modules. The term group processor circuit encompasses a processor circuit that, in combination with additional processor circuits, executes some or all code from one or more modules. References to multiple processor circuits encompass multiple processor circuits on discrete dies, multiple processor circuits on a single die, multiple cores of a single processor circuit, multiple threads of a single processor circuit, or a combination of the above. The term shared memory circuit encompasses a single memory circuit that stores some or all code from multiple modules. The term group memory circuit encompasses a memory circuit that, in combination with additional memories, stores some or all code from one or more modules.

The term memory circuit is a subset of the term computer-readable medium. The term computer-readable medium, as used herein, does not encompass transitory electrical or electromagnetic signals propagating through a medium (such as on a carrier wave); the term computer-readable medium may therefore be considered tangible and non-transitory. Non-limiting examples of a non-transitory, tangible computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The apparatuses and methods described in this application may be partially or fully implemented by a special purpose computer created by configuring a general purpose computer to execute one or more particular functions embodied in computer programs. The functional blocks, flowchart components, and other elements described above serve as software specifications, which can be translated into the computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with hardware of the special purpose computer, device drivers that interact with particular devices of the special purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

Although the terms first, second, third, etc. may be used herein to describe various elements, pumps, condenser fans, compressors, circuits, components and/or modules, these items should not be limited by these terms. These terms may be only used to distinguish one item from another item. Terms such as "first," "second," and other numerical terms when used herein do not imply a sequence or order unless clearly indicated by the context. Thus, a first item discussed herein could be termed a second item without departing from the teachings of the example implementations.

Process flowcharts discussed herein illustrate the operation of possible implementations of systems, methods, and computer program products according to various embodiments of the present invention. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A cooling system, the cooling system comprising:
a cabinet comprising a first compartment and a second compartment;
a compressor positioned within the cabinet;
an evaporator positioned within the cabinet;
a refrigerant configured to be received by the compressor and the evaporator;
at least one sensor configured to measure a refrigerant leak data;
a controller configured to determine the presence of a refrigerant leak based on the refrigerant leak data from the sensor; and
at least one sliding mechanism configured to slide in and out of the cabinet, wherein each of the at least one sliding mechanism comprises the at least one sensor.

2. The system of claim 1, wherein the cabinet comprises an opening through which a portion of the sliding mechanism is received.

3. The system of claim 1 or 2, wherein the at least one sensor and the at least one sliding mechanism are positioned adjacent to a lowest point of the cabinet when in the first position.

4. The system of any preceding claim, wherein the sliding mechanism comprises:
a guide rail disposed on the bottom of the cabinet; and
a sliding bar configured to slide along the guide rail;
wherein the at least one sensor is detachably disposed on the sliding bar; and
wherein the sliding bar is configured to slide to be completely inside the cabinet in a first position and to be outside the cabinet in a second position to expose the at least one sensor outside the cabinet.

5. The system of claim 4, wherein the at least one sensor is disposed in the second compartment when in the first position, and wherein the evaporator is positioned in the second compartment.

6. The system of any preceding claim, wherein the refrigerant leak data comprises at least one of a refrigerant concentration, a temperature, a pressure, or a humidity.

7. The system of any preceding claim, wherein the at least one sensor includes at least one of a temperature sensor, a pressure sensor, a humidity sensor, or a density sensor.

8. The cooling system of any preceding claim, wherein the refrigerant is an A2L refrigerant.

9. A sliding mechanism for a cooling system, the sliding mechanism comprising:
a guide rail;
a sliding bar received within the guide rail; and
at least one sensor detachably disposed on the sliding bar, the sensor configured to measure a refrigerant leak data;
wherein the sliding bar is configured to slide between a first position and a second position.

10. The sliding mechanism of claim 9, further comprising a controller configured to receive the refrigerant leak data from the sensor.

11. The sliding mechanism of claim 9 or 10, wherein the sensor is located at one end of the sliding bar.

12. The sliding mechanism of any of claims 9 to 11, wherein the sensor includes at least one of a temperature sensor, a pressure sensor, a humidity sensor, or a density sensor.

13. The sliding mechanism of any of claims 9 to 12, wherein the refrigerant leak data comprises at least one of a refrigerant concentration, a temperature, a pressure, or a humidity.

14. The cooling system of any of claims 9 to 13, wherein the refrigerant is an A2L refrigerant.
